# EUROPEAN PATENT APPLICATION

(11) **EP 4 693 799 A1**
(43) Date of publication of application: **11.02.2026**
(21) Application number: 23930230.0
(22) Date of filing: 24.03.2023
(51) Int. Cl.: H02J 7/00, B60L 50/60, G01R 31/389

(54) **CONTROL DEVICE AND METHOD FOR DETERMINING ALLOWABLE OUTPUT POWER OF BATTERY**

(71) Applicant: Nissan Motor Co., Ltd., Kanagawa 221-0023 (JP)
(72) Inventor: KOBAYASHI, Rei, Atsugi-shi, Kanagawa 243-0123 (JP); YAMAGISHI, Takuma, Atsugi-shi, Kanagawa 243-0021 (JP); OGAWA, Hiroshi, Atsugi-shi, Kanagawa 243-0021 (JP)
(74) Representative: Global IP Europe Patentanwaltskanzlei
(86) International application number: PCT/JP2023/011905
(87) International publication number: WO 2024/201589

(57) **Abstract**

The present invention is a control device configured to determine and control allowable output power of a battery in a battery control system. The control device comprises: a current value acquisition unit configured to acquire a present current value of current output from a battery cell constituting a battery; a voltage value acquisition unit configured to acquire a present voltage value of the battery cell; a normal allowable output power calculation unit configured to calculate normal allowable output power, based on the present voltage value; a limiting coefficient determination unit configured to calculate a voltage drop amount, based on the present voltage value and the present current value and to determine a limiting coefficient to limit the normal allowable output power, based on a temporal change amount of the voltage drop amount; a voltage drop determination unit configured to determine whether or not the present voltage value is dropped to a lower value than a previous value of the voltage value; and an allowable output power calculation unit configured to calculate, when the present voltage value is determined to be dropped to a lower value than a previous value of the voltage value by the voltage drop determination unit, allowable output power by multiplying the normal allowable output power by the limiting coefficient.

## Description

### Technical Field

The present invention relates to a control device and a method for determining allowable output power of a battery, and in particular to a control device configured to control allowable output power of a battery and a method for determining the allowable output power of the battery.

### Background Art

On vehicles, such as an electric vehicle (EV) and a hybrid vehicle (HV), large capacity and high output batteries are mounted. A control system of such a vehicle determines allowable output power according to present voltage of the battery and controls output power (discharging power) from the battery or input power (charging power) to the battery in such a way that the output power or the input power does not exceed a predetermined allowable power. Since a battery deteriorates in an internal state thereof according to a status of use of the vehicle or the like, a technology to prevent such deterioration has been proposed.

For example, Patent Document 1 described below discloses a technology for performing charge and discharge control of a secondary battery to prevent local deterioration inside the battery, based on a battery model that allows prediction of an internal state of the battery.

### Citation List

### Patent Literature

Patent Document 1: JP 2007-141558 A

### Summary of Invention

### Technical Problem

The technology described in Patent Document 1 described above predicts the present state inside the battery, but does not predict the amount of voltage drop when a large current flows from or to the battery, and thus has not been able to appropriately predict the drop in battery voltage. Among other things, in a case where the internal deterioration inside the battery progresses or where the battery is used in a harsh environment, the drop in the battery voltage becomes steep, and the control of output voltage cannot respond quickly enough to keep up. In addition, since the technology uses an actual current value from a sensor for prediction of the state, it is difficult to predict the amount of voltage drop when a large current flows, and it is not possible to perform control assuming the worst-case situation.

Accordingly, an object of the present invention is to provide a technology capable of determining appropriate allowable output power according to a temporal change amount of a voltage drop amount of a battery.

### Solution to Problem

The present invention according to one aspect is a control device configured to determine and control allowable output power of a battery in a battery control system. The control device comprises: a current value acquisition unit configured to acquire a present current value of current output from a battery cell constituting a battery; a voltage value acquisition unit configured to acquire a present voltage value of the battery cell; a normal allowable output power calculation unit configured to calculate normal allowable output power, based on the present voltage value; a limiting coefficient determination unit configured to calculate a voltage drop amount, based on the present voltage value and the present current value and to determine a limiting coefficient to limit the normal allowable output power, based on a temporal change amount of the voltage drop amount; a voltage drop determination unit configured to determine whether or not the present voltage value is dropped to a lower value than a previous value of the voltage value; and an allowable output power calculation unit configured to calculate, when the present voltage value is determined to be dropped to a lower value than a previous value of the voltage value by the voltage drop determination unit, allowable output power by multiplying the normal allowable output power by the limiting coefficient.

In addition, the present invention according to another aspect is a method for determining allowable output power of a battery. The method includes: acquiring a present current value of current output from a battery cell constituting the battery; acquiring a present voltage value of the battery cell; calculating normal allowable output power, based on the present voltage value; calculating a voltage drop amount, based on the present voltage value and the present current value and calculating a temporal change amount of the voltage drop amount; determining a limiting coefficient to limit the normal allowable output power, based on a temporal change amount of the voltage drop amount; determining whether or not the present voltage value is dropped to a lower value than a previous value of the voltage value; and calculating, when the present voltage value is determined to be dropped to a lower value than a previous value of voltage value, allowable output power by multiplying the normal allowable output power by the limiting coefficient.

It is noted that in the description of the present invention or the like, the term "means" does not simply means a physical means, but also includes a case where a function that the means has is implemented by software. In addition, a function that one means has may be achieved by two or more physical means, and functions of two or more means may be achieved by one physical means. In addition, the term "system" refers to a logical assembly of a plurality of devices (or function modules each achieving a particular function), and it does not particularly matter whether or not the respective devices or function modules are contained in a single housing.

### Advantageous Effects of Invention

According to the present invention, it is possible to determine appropriate allowable output power, based on a temporal change amount of a voltage drop amount of a battery. Therefore, it is possible to suppress the battery from outputting power that exceeds the allowable output power and prevent unintended abrupt voltage drop while the battery is in use.

Other technical features, objects, actions and effects, and advantages of the present invention will become apparent from the following embodiments described with reference to the attached drawings. Advantageous effects described herein are merely illustrative and not restrictive, and may have another advantageous effect.

### Brief Description of Drawings

FIG. 1 is a block diagram illustrative of an example of a schematic configuration of a battery control system according to one embodiment of the present invention.
FIG. 2 is a block diagram illustrative of an example of a functional configuration of a control device according to the one embodiment of the present invention.
FIG. 3 is a graph for a description of a return amount of limited allowable output power in the control device according to the one embodiment of the present invention.
FIG. 4 is a flowchart descriptive of an example of processing to determine allowable output power performed by the control device according to the one embodiment of the present invention.
FIG. 5 is a flowchart descriptive of an example of calculation processing of a limiting coefficient performed by the control device according to the one embodiment of the present invention.

### Description of Embodiments

An embodiment of the present invention will be described below with reference to the drawings. However, the embodiment to be described below is only an example, and there is no intention to exclude various modifications or application of technologies not explicitly described below. The present invention can be subjected to various modifications (such as combining embodiments) without departing from the scope of the present invention. In addition, in the following description of the drawings, the same or similar parts are designated by the same or similar reference signs. The drawings are schematic, and dimensions, ratios, or the like do not necessarily coincide with actual dimensions, ratios, or the like. There may also be portions where the dimensional relationship or the ratio differs between the drawings.

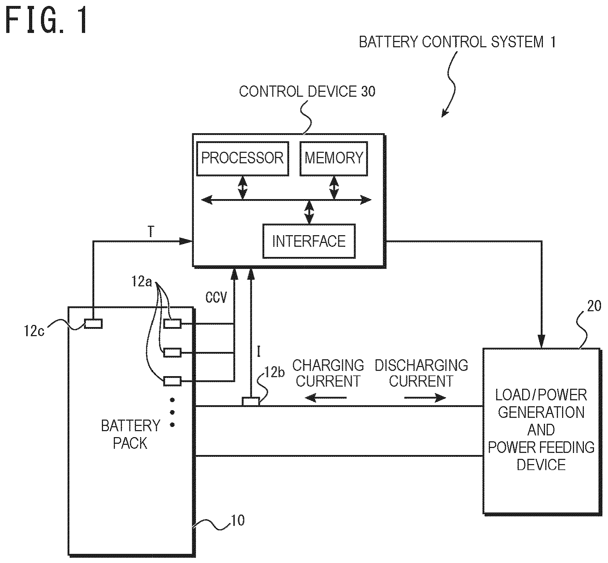

FIG. 1 is a block diagram illustrative of an example of a schematic configuration of a battery control system according to one embodiment of the present invention. As illustrated in this figure, a battery control system 1 includes, for example, a battery pack 10, a load 20, and a control device 30. The battery control system 1 as described above is mounted on a vehicle.

The battery pack 10 is a battery that is formed by assembling a plurality of batteries that are referred to as unit cells and are minimum structural units. In the present disclosure, in accordance with convention, when an element is referred to as a battery, the element refers to a battery that includes the entire group of unit cells (*i.e.,* the battery pack 10), and when an element is referred to as a battery cell, the element refers to each unit cell. The battery is typically a lithium-ion battery, but is not limited thereto.

The battery pack 10 is formed including various types of sensors 12. The sensors 12 include, for example, voltage sensors 12a, a current sensor 12b, and a temperature sensor 12c. A voltage sensor 12a is provided for each battery cell, and measures voltage of the battery cell and outputs a measurement value of the voltage (voltage V) to the control device 30. When the vehicle and a system thereof are operating and the battery is powered on, the voltage V measured by each voltage sensor 12a is operating voltage or closed circuit voltage (CCV). The current sensor 12b measures a value of current output from the battery pack 10 (or current input to the battery pack 10) and outputs a measurement value of the current (current I) to the control device 30. The temperature sensor 12c measures temperature of the battery cells or some groups of battery cells and outputs a measurement value to the control device 30.

The load 20 is high-voltage equipment that consumes power supplied (output) from the battery pack 10. Typically, the load 20 is a motor to drive wheels of the vehicle. The motor is drive-controlled by an inverter circuit (not illustrated) under the control of the control device 30. In addition, the load 20 may include a function as a power generation device or a power feeding device. Therefore, the battery pack 10 can be charged by power supplied from the load 20 serving as a power generation device or a power feeding device.

The control device 30 controls current or power output (supplied) from the battery pack 10 to the load 20 in the battery control system 1. The control device 30 includes a processor, a memory, an interface, and the like.

Schematically, the control device 30 calculates a voltage drop amount Δv for each battery cell, based on measurement values of the voltage V, the current I, and the like output from the various types of sensors 12 of the battery pack 10, transitions from a normal mode to a limiting mode depending on a temporal change amount of the calculated voltage drop amount Δv, and determines a limiting coefficient k for allowable output power W. The control device 30 calculates the allowable output power W, based on the determined limiting coefficient k and controls the inverter for the load 20 in such a way that power exceeding the allowable output power W is not supplied from the battery.

In the present disclosure, the temporal change amount of the voltage drop amount Δv refers to a voltage drop amount per predetermined time Δt (*i.e.,* Δv/Δt) and is sometimes referred to as voltage drop speed. In the limiting mode, the allowable output power W is more limited than in the normal mode lest an abrupt drop in the voltage V of each battery cell or the like occur. That is, when the temporal change amount of the voltage drop amount Δv of the battery cell is greater than a normally conceivable change amount (state), the limiting coefficient k is determined in such a way that the allowable output power W is more limited than in normal conditions. In other words, a region where the temporal change amount of the voltage drop amount Δv of the battery cell is greater than the normally conceivable change amount is a region where behavior of the voltage V of the battery cell is unstable (a region where a so-called hunting phenomenon occurs). Therefore, in such a region where the behavior of the voltage V of the battery cell is unstable, it is possible to facilitate recovery (guidance to a proper voltage drop amount Δv) of the battery cell by persistently further limiting the allowable output power W, using a predetermined limiting coefficient k, regardless of the temporal change amount of the voltage drop amount Δv.

In addition, in the limiting mode, the control device 30 relaxes the allowable output power W with a return amount Δw every time when the voltage V of the battery cell comes close to a normal state. By this configuration, even when the voltage V of the battery cell has recovered, it becomes possible to gradually stabilize a state of output from the battery cell without immediately canceling the limiting mode and transitioning to the normal mode.

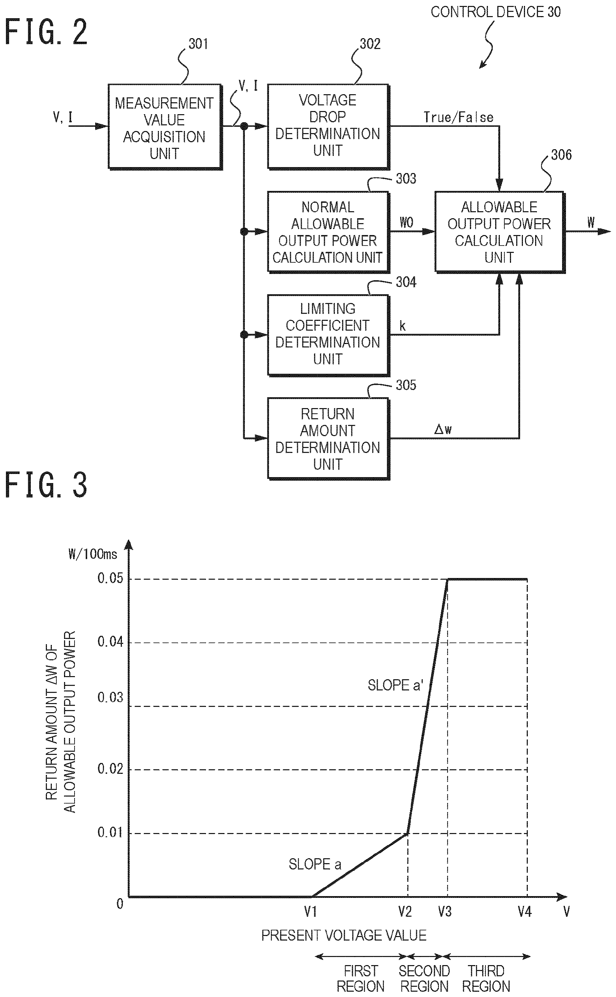

FIG. 2 is a block diagram illustrative of an example of a functional configuration of the control device according to the one embodiment of the present invention. As illustrated in this drawing, the control device 30 of the present embodiment includes functional constituent elements such as a measurement value acquisition unit 301, a voltage drop determination unit 302, a normal allowable output power calculation unit 303, a limiting coefficient determination unit 304, a return amount determination unit 305, and an allowable output power calculation unit 306. It is noted that a functional constituent element may be integrally formed with another functional constituent element or may be decomposed into several functional constituent elements.

The measurement value acquisition unit 301 acquires measurement values that are measured and output by the various types of sensors 12 of the battery pack 10, every unit time. Specifically, the measurement value acquisition unit 301 acquires present voltage V of each battery cell from one of the voltage sensors 12a and also acquires present current I from the current sensor 12b, for example, every 100 ms. A current value acquisition unit and a voltage value acquisition unit are examples of specific modes of embodiment of the measurement value acquisition unit 301. The measurement value acquisition unit 301 may acquire a lowest voltage V (lowest cell voltage) among the voltages V measured with respect to the respective battery cells. By using the lowest cell voltage in this way, it is possible to more strictly limit the allowable output power W, as a result of which it becomes possible to avoid an abrupt drop and the like in the output voltage of the battery. In addition, the measurement value acquisition unit 301 can acquire present temperature of the battery from the temperature sensor 12c. The measurement value acquisition unit 301 transmits the above-described acquired measurement values to each of the voltage drop determination unit 302, the normal allowable output power calculation unit 303, the limiting coefficient determination unit 304, and the return amount determination unit 305.

The voltage drop determination unit 302 compares the acquired present voltage V with voltage V acquired one unit time (*e.g.,* 100 ms) before and determines whether or not there has been a drop in the voltage V. The voltage drop determination unit 302 notifies the allowable output power calculation unit 306 of a result of determining whether or not there has been a drop in the voltage V. The voltage drop determination unit 302 stores the acquired present voltage V in, for example, a register (not illustrated) to compare the present voltage V with voltage V to be acquired at the next timing.

The normal allowable output power calculation unit 303 calculates a normal allowable output power WO, based on the voltage V acquired via the measurement value acquisition unit 301. The normal allowable output power calculation unit 303 includes, for example, a mapping table for the calculation of the normal allowable output power WO. That is, the normal allowable output power calculation unit 303 calculates the normal allowable output power WO corresponding to the voltage V with reference to the mapping table by using, as input, the acquired voltage V. The normal allowable output power calculation unit 303 may be configured to correct the normal allowable output power WO according to the measured temperature. The normal allowable output power calculation unit 303 transmits the normal allowable output power WO to the allowable output power calculation unit 306.

The limiting coefficient determination unit 304 calculates or determines a limiting coefficient k to limit the allowable output power W, based on a temporal change amount of a voltage drop amount Δv of each battery cell (*i.e.,* Δv/Δt). The voltage drop amount Δv is calculated based on the acquired current I and internal resistance R of the battery cell matching the current I. Schematically, in the normal mode, the limiting coefficient determination unit 304 determines whether or not a temporal change amount of the calculated voltage drop amount Δv is greater than or equal to a predetermined threshold value and, when determining that the temporal change amount of the voltage drop amount Δv is greater than or equal to the predetermined threshold value, causes an operation mode to transition from the normal mode to the limiting mode and determines the limiting coefficient k in such a way as to limit the allowable output power W. In the limiting mode, the limiting coefficient k has a value greater than 0 and less than 1. Whether the operation mode is the normal mode or the limiting mode depends on a value of a limiting mode limiting coefficient k1, as described later. The limiting coefficient k is set to either a normal mode limiting coefficient k0 that corresponds to a normally conceivable temporal change amount of the voltage drop amount Δv or the limiting mode limiting coefficient k1 that is a limiting coefficient when the temporal change amount of the voltage drop amount Δv is greater than or equal to the predetermined threshold value.

In addition, during the limiting mode, when determining that the acquired present voltage V is greater than or equal to a limiting start voltage V0 that is a voltage at a time point when the operation mode transitioned to the limiting mode, the limiting coefficient determination unit 304 has the limiting mode canceled and causes the operation mode to transition to the normal mode (k1 = 1), whereas, when determining that the acquired current voltage V has not returned to the limiting start voltage V0, the limiting coefficient determination unit 304 updates the limiting mode limiting coefficient k1 in such a way that a value of the limiting coefficient k further diminishes (*i.e.,* in such a way that the allowable output power W is further limited). Transition to the normal mode in this way when the present voltage V returns to the limiting start voltage V0 causes the allowable output power W to be optimized.

The return amount determination unit 305 determines a return amount (mitigation amount) Δw to change the present allowable output power W to a new allowable output power W by relaxing a limit to the present allowable output power W, according to the present voltage V. The normal allowable output power calculation unit 303 includes, for example, a mapping table for calculation of the return amount Δw. That is, the return amount determination unit 305 determines the return amount Δw corresponding to the voltage V with reference to a mapping table by using, as input, the acquired voltage V, as represented by, for example, a graph illustrated in FIG. 3. For example, the return amount Δw is set to increase with a slope a as the voltage V increases from a voltage value v1 (V) to a voltage value v2 (V) and increase with a slope a' (a' > a) as the voltage V increases from the voltage value v2 (V) to a voltage value v3 (V). In addition, the return amount Δw becomes constant when the voltage V is the voltage value v3 (V) or more. By gradually returning the allowable output power W with the variable return amount Δw in this way, it becomes possible to gradually stabilize the behavior of the voltage V of the battery cells when the voltage V of the battery cells has recovered. Among other things, since in a region where the behavior of the voltage V of the battery cells is unstable (a first region; in the present example, a region where the voltage V is less than v2 (V)), incremental change in the return amount Δw (first incremental change) is set smaller and in a region where the voltage V of the battery cells is recovering (a second region; in the present example, a region where the voltage V is v2 (V) or more and less than v3 (V)), the incremental change in the return amount Δw (second incremental change) is set larger, it becomes possible to stabilize the behavior of the voltage V of the battery cells. Further, in a region where the voltage V of the battery cells has sufficiently recovered (a third region; in the present example, a region where the voltage V is v3 (V) or more), by keeping the return amount Δw constant, it becomes possible to obtain optimal allowable output power W matching the voltage V of the battery cells. The return amount determination unit 305 transmits the determined return amount Δw to the allowable output power calculation unit 306.

The allowable output power calculation unit 306 determines the allowable output power W according to a determination result by the voltage drop determination unit 302. That is, when a determination result by the voltage drop determination unit 302 indicates that there has been a reduction in the voltage V, the allowable output power calculation unit 306 determines a new allowable output power W, based on the present normal allowable output power WO and the limiting coefficient k. In contrast, when the determination result by the voltage drop determination unit 302 indicates that there has been no droop in the voltage V, the allowable output power calculation unit 306 determines a new allowable output power W, based on the present allowable output power W and the return amount Δw. By this configuration, since the power supplied from battery pack 10 is controlled in such a way as not to exceed the allowable output power W, it becomes possible to prevent unintended abrupt voltage drops in the battery due to excessive power supply.

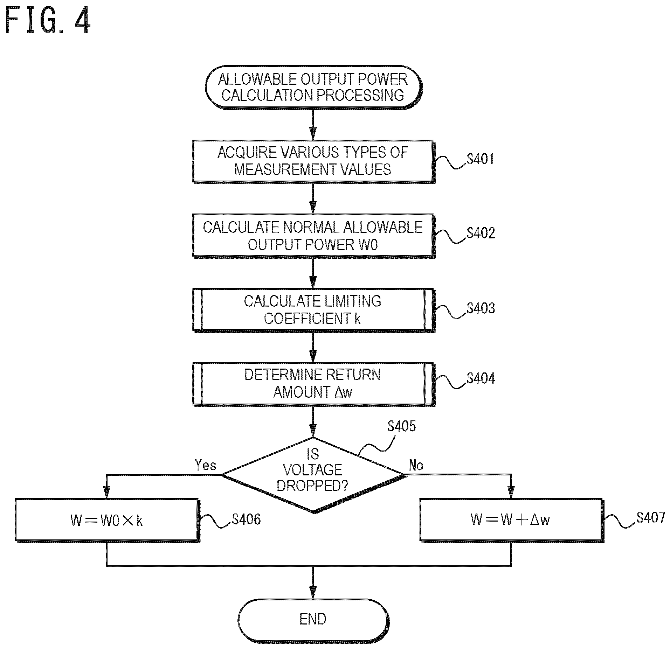

FIG. 4 is a flowchart descriptive of an example of processing to determine allowable output power performed by the control device according to the one embodiment of the present invention. Such processing is achieved by the control device 30 executing, under the control of the processor, a predetermined battery control program in collaboration with predetermined hardware resources. The control device 30 operates in such a way that the allowable output power W is determined, for example, every 100 ms through such processing.

As illustrated in this figure, the control device 30 acquires measurement values measured by the various types of sensors 12 of the battery pack 10 (S401). That is, the control device 30 acquires present voltage V of the battery cells from the voltage sensors 12a and also acquires present current I from the current sensor 12b. In addition, the measurement value acquisition unit 301 can acquire present temperature T of the battery from the temperature sensor 12c.

Next, the control device 30 calculates normal allowable output power WO matching a normally conceivable voltage drop amount Δv of the battery cells, based on the acquired voltage V (S402). That is, the control device 30 accepts as input the acquired voltage V and calculates the normal allowable output power WO corresponding to the voltage V with reference to a mapping table. As the voltage V, a lowest cell voltage may be used.

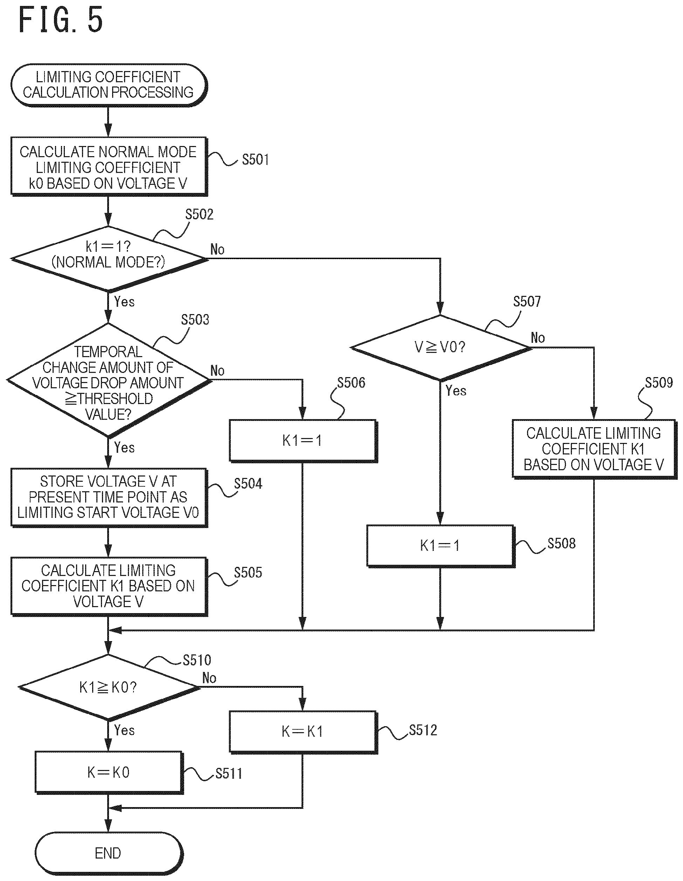

Next, the control device 30 calculates a limiting coefficient k to limit the allowable output power W (S403). The calculation of the limiting coefficient k will be described later (see FIG. 5). Next, the control device 30 determines a return amount Δw to change the present allowable output power W to a new allowable output power W, according to the present voltage V (S404). That is, the control device 30, as described above, determines the return amount Δw corresponding to the voltage V with reference to a mapping table by using, as input, the acquired voltage V, as represented by, for example, a graph illustrated in FIG. 3.

Next, the control device 30 determines whether or not there has been a drop in the voltage V, based on the acquired present voltage V and voltage V one unit time (for example, 100 ms) before that is stored in the register (S405). When the control device 30 determines that there has been a drop in the voltage V (Yes in S405), the control device 30 calculates a new allowable output power W by multiplying the calculated normal allowable output power WO by the limiting coefficient k (that is, W = WO × k) (S406).

In contrast, when the control device 30 determines that there has been no drop in the voltage V (No in S405), the control device 30 calculates a new allowable output power W by adding the return amount Δw to the present allowable output power W (*i.e.*, W = W + Δw) (S406) .

In a manner as described above, the control device 30 is able to control power supplied from the battery pack 10 in such a way that the power does not exceed the allowable output power W, and it is possible to prevent an unintended abrupt voltage drop while the battery is in use.

FIG. 5 is a flowchart descriptive of an example of calculation processing of a limiting coefficient performed by the control device according to the one embodiment of the present invention. The drawing illustrates details of the processing in step S403 in FIG. 4.

Specifically, as illustrated in the drawing, the control device 30 calculates a normal mode limiting coefficient k0 matching a normally conceivable voltage drop amount Δv of the battery cells, based on the present voltage V. The calculation of the normal mode limiting coefficient k0 is, for example, performed using a mapping table.

Next, the control device 30 determines whether or not the limiting mode limiting coefficient k1 is 1 (S502). In this step, when the limiting mode limiting coefficient k1 is 1, it is indicated that the operation mode is the normal mode, and when the limiting mode limiting coefficient k1 is less than 1, it is indicated that the operation mode is the limiting mode in which the allowable output power W is more limited. When the control device 30 determines that the limiting mode limiting coefficient k1 is 1, that is, the present operation mode is the normal mode (Yes in S502), the control device 30 subsequently determines whether or not a temporal change amount of the voltage drop amount Δv is greater than or equal to a predetermined threshold value (S503). As used herein, the temporal change amount of the voltage drop amount Δv refers to a voltage drop amount per predetermined time Δt (Δv/Δt).

When the control device 30 determines that the temporal change amount of the voltage drop amount Δv is greater than or equal to the predetermined threshold value (Yes in S503), the control device 30 stores the present voltage V in, for example, the register as a limiting start voltage V0 (S504).

Subsequently, the control device 30 calculates a limiting mode limiting coefficient k1 (where k1 < 1) matching the voltage drop amount Δv in the limiting mode, based on the present voltage V (S505). The calculation of the limiting mode limiting coefficient k1 is, for example, carried out using a mapping table. Therefore, the limiting mode limiting coefficient k1 being set to a value less than 1 causes the operation mode to transition from the normal mode to the limiting mode.

In contrast, when the control device 30 determines that the temporal change amount of the voltage drop amount Δv is not greater than or equal to the predetermined threshold value (No in S503), the control device 30 sets the limiting mode limiting coefficient k1 to 1 (S506). Therefore, the operation mode is maintained in the normal mode.

In addition, when the control device 30 determines that the limiting coefficient k1 is not 1, that is, the operation mode is the limiting mode (No in S502), the control device 30 subsequently determines whether or not the present voltage V is greater than or equal to the limiting start voltage V0 (S507). In other words, the control device 30 determines whether or not the present voltage V has returned to the limiting start voltage V0 during the limiting mode.

When the control device 30 determines that the present voltage V is greater than or equal to the limiting start voltage V0 (Yes in S507), the control device 30 sets the limiting mode limiting coefficient k1 to 1 (S508). Therefore, the operation mode is caused to transition from the limiting mode to the normal mode. In other words, when the voltage V has returned to the limiting start voltage V0, which is a voltage at the start time point of the limiting mode, during the limiting mode, in which the allowable output power W is limited, the limiting mode is canceled in consideration of the state of the battery having recovered or being in the process of recovering to the normal state. By way of this, it is possible to avoid limiting the allowable output power W more than necessary.

In contrast, when the control device 30 determines that the present voltage V is not greater than or equal to the limiting start voltage V0 (No in S507), the control device 30 calculates a limiting mode limiting coefficient k1 matching the voltage drop amount Δv in the limiting mode, based on the voltage V in accordance with the mapping table (S509). In other words, when the voltage V has not returned to the limiting start voltage V0 despite the operation mode being the limiting mode, the control device 30 updates the limiting coefficient k1, based on the present voltage V to further limit the allowable output power W.

When the normal mode limiting coefficient k0 and the limiting mode limiting coefficient k1 are determined in this way, the control device 30 next determines whether or not the limiting mode limiting coefficient k1 is greater than or equal to the normal mode limiting coefficient k0 (S510). When the control device 30 determines that the limiting mode limiting coefficient k1 is greater than or equal to the normal mode limiting coefficient k0 (Yes in S510), the control device 30 sets the limiting coefficient k with the normal mode limiting coefficient k0 (that is, k=k0) (S511). In contrast, when the control device 30 determines that the limiting mode limiting coefficient k1 is not greater than or equal to the normal mode limiting coefficient k0 (No in S510), the control device 30 sets the limiting coefficient k with the limiting mode limiting coefficient k1 (that is, k=k1) (S511). In other words, the control device 30 compares the limiting mode limiting coefficient k1 and the normal mode limiting coefficient k0 with each other and selects one with a smaller value (having a stricter limit) of the limiting mode limiting coefficient k1 and the normal mode limiting coefficient k0 as the limiting coefficient k. Because of this configuration, it is possible to more strictly limit the allowable output power W, as a result of which it becomes possible to avoid an unintended abrupt voltage drop while the battery is in use.

As described above, according to the present embodiment, since the operation mode transitions to the limiting mode depending on the temporal change amount of the voltage drop amount Δv of the battery cells and the allowable output power W is limited by the limiting coefficient k, it is possible to more reliably limit the allowable output power W, facilitate the recovery of the battery cell, and prevent an unintended abrupt voltage drop of the battery cells. Among other things, according to the present embodiment, since the temporal change amount of the voltage drop amount Δv of the battery cells is compared with a predetermined threshold value, it is possible to detect a region where the behavior of the voltage V of the battery cells becomes unstable, and it becomes possible to limit the allowable output power W in accordance with an appropriate limiting coefficient k in the unstable region.

In addition, according to the present embodiment, since in the limiting mode, the allowable output power W is gradually relaxed with a variable return amount Δw every time when the voltage v of the battery cell comes close to the normal state, it becomes possible to gradually stabilize the state of output from the battery cell. In particular, since in the region where the behavior of the voltage V of the battery cell is unstable (the first region; in the present example, the region where the voltage V is less than v2 (V)), incremental change in the return amount Δw with respect to the voltage value (the first incremental change) is set smaller and in the region where the voltage V of the battery cell is recovering (the second region; in the present example, the region where the voltage V is v2 (V) or more and less than v3 (V)), the incremental change in the return amount Δw with respect to the voltage value (the second incremental change) is set larger, it becomes possible to stabilize the behavior of the voltage V of the battery cell. Further, in the region where the voltage V of the battery cell has sufficiently recovered (the third region; in the present example, the region where the voltage V is v3 (V) or more), by keeping the return amount Δw constant with respect to the voltage value, it becomes possible to obtain optimal allowable output power W matching the voltage V of the battery cell.

The above-described embodiments are examples for describing the present invention and are not intended to limit the present invention only to the embodiments. The present invention can be implemented in a variety of modes without departing from the scope and spirit of the present invention.

For example, in the method disclosed herein, the steps, operations, or functions may be implemented concurrently or in different orders, as long as there is no inconsistency in the result. The described steps, operations, and functions have been provided as just examples, and in the scope without departing from the spirit of the present invention, some of the steps, operations, and functions can be omitted or can be combined with each other into one, and other steps, operations, or functions may be added.

Further, although a variety of embodiments are disclosed herein, a particular feature (technical matter) in an embodiment can be appropriately improved, and therewith, can be added to an alternative embodiment or can be replaced by the particular feature in the alternative embodiment, and such modes also fall within the spirit of the present invention.

### Reference Signs List

- 1: Battery control system
- 10: Battery pack
12 Sensor
12a Voltage sensor
12b Current sensor
12c Temperature sensor
- 20: Load
- 30: Control device
301 Measurement value acquisition unit
302 Voltage drop determination unit
303 Normal allowable output power calculation unit
304 Limiting coefficient determination unit
305 Return amount determination unit
306 Allowable output power calculation unit

## Claims

1. A control device in a battery control system, comprising:
a current value acquisition unit configured to acquire a present current value of current output from a battery cell constituting a battery;
a voltage value acquisition unit configured to acquire a present voltage value of the battery cell;
a normal allowable output power calculation unit configured to calculate normal allowable output power, based on the present voltage value;
a limiting coefficient determination unit configured to calculate a voltage drop amount, based on the present voltage value and the present current value and to determine a limiting coefficient to limit the normal allowable output power, based on a temporal change amount of the voltage drop amount;
a voltage drop determination unit configured to determine whether or not the present voltage value is dropped to a lower value than a previous value of the voltage value; and
an allowable output power calculation unit configured to calculate, when the present voltage value is determined to be dropped to a lower value than a previous value of the voltage value by the voltage drop determination unit, allowable output power by multiplying the normal allowable output power by the limiting coefficient.

2. The control device according to claim 1,
wherein the limiting coefficient determination unit
causes, when, in a normal mode, determining that a temporal change amount of the voltage drop amount is greater than or equal to a predetermined threshold value, the control device to transition from the normal mode to the limiting mode and to calculates a limiting mode limiting coefficient, based on the voltage value, and
determines the limiting coefficient, based on the limiting mode limiting coefficient.

3. The control device according to claim 2,
wherein the limiting coefficient determination unit
calculates, when in the limiting mode, the present voltage value is less than the voltage value at a time point when the control device transitions from the normal mode to the limiting mode, the limiting mode limiting coefficient, based on the present voltage value in such a way that the normal allowable output power is further limited, and
determines the limiting coefficient, based on the limiting mode limiting coefficient.

4. The control device according to claim 2, wherein the limiting coefficient determination unit causes, when in the limiting mode, the present voltage value is greater than or equal to the voltage value at a time point when the control device transitions from the normal mode to the limiting mode, the control device to transition from the limiting mode to the normal mode.

5. The control device according to claim 2, wherein the limiting coefficient determination unit
calculates, in the normal mode, a normal mode limiting coefficient, based on the voltage value, and
determines, when the limiting mode limiting coefficient is greater than or equal to the normal mode limiting coefficient, the normal mode limiting coefficient as the limiting coefficient and determines, when the limiting mode limiting coefficient is less than the normal mode limiting coefficient, the normal mode limiting coefficient as the limiting coefficient.

6. The control device according to claim 1 further comprising
a return amount determination unit configured to variably determine a return amount according to the present voltage value,
wherein the allowable output power calculation unit calculates, when the present voltage value is determined not to be dropped to a lower value than a previous value of the voltage value by the voltage drop determination unit, a new value of the allowable output power obtained by relaxing a present value of the allowable output power with the return amount.

7. The control device according to claim 6,
wherein the return amount determination unit
determines, when the present voltage value falls within a first region, a return amount having first incremental change with respect to the present voltage as the return amount and
determines, when the present voltage value falls within a second region where the voltage value is higher than in the first region, a return amount having second incremental change, the second incremental change being greater than the first incremental change, with respect to the present voltage as the return amount.

8. The control device according to claim 7,
wherein the return amount determination unit determines, when the present voltage value falls within a third region, a return amount, the return amount being constant with respect to the present voltage, as the return amount.

9. The control device according to claim 1,
wherein the voltage value acquired by the voltage value acquisition unit is a lowest voltage value among a plurality of the battery cells.

10. A method for determining allowable output power of a battery, the method comprising:
acquiring a present current value of current output from a battery cell constituting the battery;
acquiring a present voltage value of the battery cell;
calculating normal allowable output power, based on the present voltage value;
calculating a voltage drop amount, based on the present voltage value and the present current value and calculating a temporal change amount of the voltage drop amount;
determining a limiting coefficient to limit the normal allowable output power, based on a temporal change amount of the voltage drop amount;
determining whether or not the present voltage value is dropped to a lower value than a previous value of the voltage value; and
calculating, when the present voltage value is determined to be dropped to a lower value than a previous value of the voltage value, allowable output power by multiplying the normal allowable output power by the limiting coefficient.
